# EUROPEAN PATENT SPECIFICATION

(11) **EP 2 426 746 B1**
(45) Date of publication and mention of the grant of the patent: **27.06.2018**
(21) Application number: 10769588.4
(22) Date of filing: 31.03.2010
(51) Int. Cl.: H01L 33/60, H01L 25/07, F21V 7/22, F21V 7/00, F21Y 115/10

(54) **LIGHT EMITTING DEVICE**
LICHTEMITTIERENDE VORRICHTUNG
DISPOSITIF ÉLECTROLUMINESCENT

(30) Priority: 27.04.2009 JP 2009107909
(43) Date of publication of application: 07.03.2012
(73) Proprietor: KYOCERA Corporation, Kyoto 612-8501 (JP)
(72) Inventor: SAKUMOTO, Daisuke, Higashiomi-shi Shiga 529-1595 (JP)
(74) Representative: Viering, Jentschura & Partner mbB Patent- und Rechtsanwälte
(86) International application number: PCT/JP2010/055837
(87) International publication number: WO 2010/125889

(56) References cited:
- EP-A2- 1 182 395
- WO-A1-2008/120538
- WO-A2-2007/113768
- JP-A- 5 275 748
- JP-A- 2005 293 994
- JP-A- 2006 252 841
- JP-A- 2007 052 994
- JP-A- 2008 159 562
- JP-A- 2008 159 562
- JP-A- 2008 244 220

## Description

### Technical Field

The present invention relates to a light emitting device having a light emitting element such as a light emitting diode.

### Background Art

In recent years, in place of conventional light emitting devices such as fluorescent lamps or incandescent lamps, light emitting devices have been developed which include a light source having a light emitting element such as a light emitting diode. Light emitting devices including a light emitting element are anticipated from the point of view of power consumption and product lifetime in comparison to conventional light emitting devices.

EP 1182395 A2 discloses a LED lighting equipment for vehicle comprising at least one light emitting unit which comprises a first reflection surface of hyperboloid and a second reflecting surface of paraboloid of revolution. Besides, a LED lamp is disposed at a predetermined position in respect to said reflection surface of hyperboloid.

### Summary of Invention

An object of the invention is to provide a light emitting device including a light emitting element, the size of a light source is smaller than that of conventional light emitting devices, and thus a light intensity distribution is required to be improved.

The above object is accomplished by claim 1.

According to an aspect of the invention, a light emitting device includes a plurality of light sources each including a light emitting element, a first light reflective member which surrounds the plurality of light sources, and a second light reflective member disposed ahead of the first light reflective member in a light radiation direction of the plurality of light sources with reference to the plurality of light sources. The second light reflective member includes a light transmitting material.

### Brief Description of Drawings

Fig. 1 shows a perspective view of a light emitting device according to a first embodiment of the invention;
Fig. 2 shows a perspective view of a light emitting unit 90 shown in Fig. 1;
Fig. 3 shows a vertical section view taken along the line A-A of the light emitting unit shown in Fig. 2;
Fig. 4 shows a vertical section view of an exemplary light emitting unit 1;
Fig. 5 shows a vertical section view of another exemplary light emitting unit 1;
Fig. 6 shows a section view partially of a light source 12;
Fig. 7 schematically shows a light intensity distribution of the light emitting unit 90;
Fig. 8 schematically shows a light intensity distribution of the another light source unit 1;
Fig. 9 schematically shows how light propagates from a light source unit 90 in a light emitting device according to a second embodiment of the invention;
Fig. 10 schematically shows how light propagates from a light source unit 90 in a light emitting device according to a third embodiment of the invention; and
Fig. 11 schematically shows how light propagates from a light source unit 90 in a light emitting device according to a fourth embodiment of the invention.

### Best Mode for Carrying out the Invention

Now referring to the drawings, exemplary embodiments of the invention are described below.

### (First Embodiment)

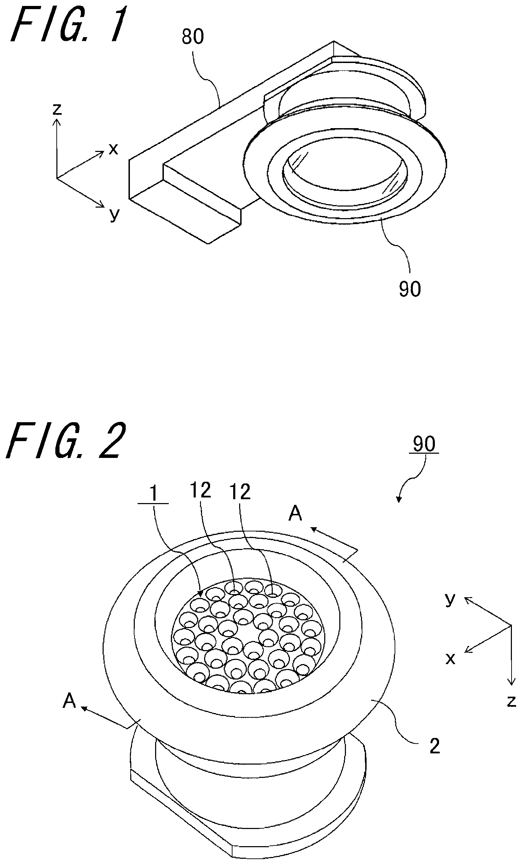

A light emitting device according to a first embodiment of the invention will be described with reference to Fig. 1. The light emitting device includes a power source unit 80 and a light emitting unit 90 electrically connected to the power source unit 80. In Fig. 1, the light emitting device is disposed in an imaginary xyz space. An upper direction in Fig. 1 indicates a positive direction of an imaginary z axis.

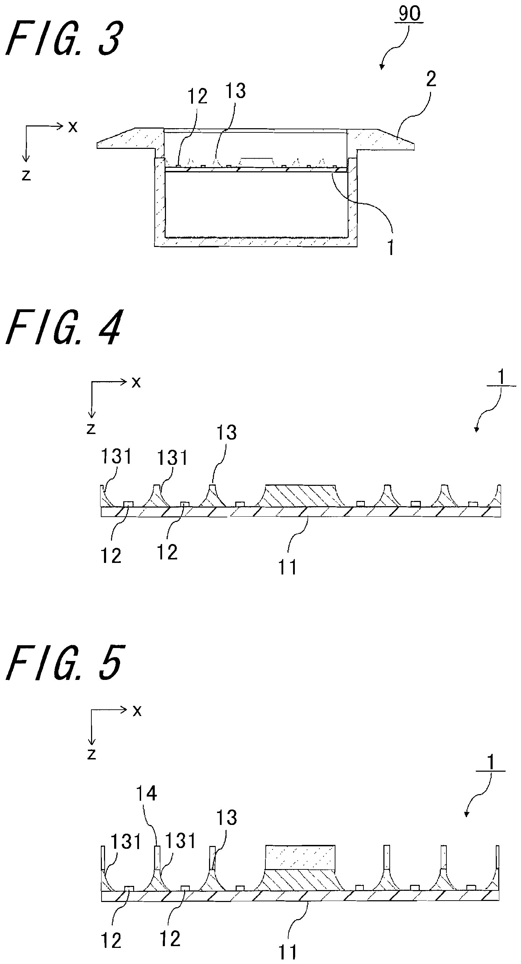

As shown in Figs. 2 and 3, the light emitting unit 90 includes a light source unit 1 and a light reflective member 2. In Fig. 3, an inner structure of the light emitting unit 90 is partially omitted.

As shown in Fig. 4, an exemplary light source unit 1 includes a mounting substrate 11, a plurality of light sources 12 disposed on the mounting substrate 11, and a light reflective member 13 disposed on the mounting substrate 11. The light reflective member 13 has a plurality of light reflective surfaces 131 which are disposed corresponding to the plurality of light sources 12. The light reflective surfaces 131 surround the light sources 12 and have, for example, a paraboloid shape. The light reflective surfaces 131 reflect light radiated from the light sources 12 in a negative direction of the imaginary z axis.

As shown in Fig. 5, another exemplary light source unit 1 further includes a light reflective member 14 which is disposed ahead of the light reflective member 13 in a light radiation direction of the light sources 12 with reference to the light sources 12. In Fig. 5, the "light radiation direction of the light sources 12" indicates the negative direction of the imaginary z axis. The light reflective member 2 includes a light transmitting material. The "light transmitting property" of the light reflective member 2 means that at least some of light rays radiated from the light source 12 can pass through the light reflective member. Examples of the light transmitting material include polymethylmethacrylate (PMMA), acrylic resin, polybutylene terephthalate, polypropylene, acrylonitrile-butadiene-styrene copolymer synthetic resin (ABS resin), polycarbonate, polyester, polyethylene and epoxy resin.

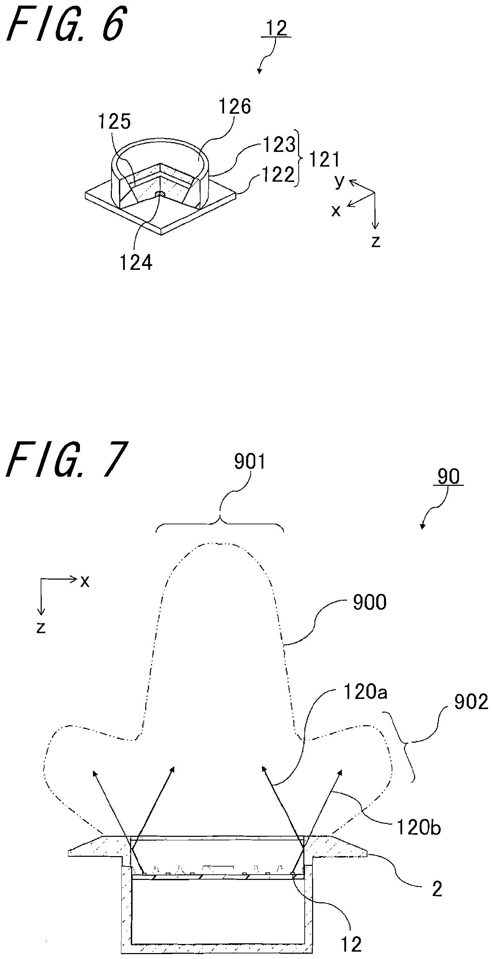

As shown in Fig. 6, the light source 12 includes a package 121, a light emitting element 124 mounted on the package 121, a light transmitting member 125 enclosing the light emitting element 124, and a wavelength conversion member 126 disposed on or above the light transmitting member 125. An upper direction in Fig. 6 indicates the negative direction of the imaginary z axis.

The package 121 includes a base 122 and a frame member 123 disposed on the base 122. The frame member 123 surrounds the light emitting element 124.

The light emitting element 124 is, for example, a semiconductor device such as a light emitting diode (LED) and radiates primary light in response to driving power.

The light transmitting member 125 is disposed inside the frame member 123 and covers the light emitting element 124. The "light transmitting property" of the member 125 means that a wavelength of at least some of light rays radiated from the light emitting element 124 can pass through the light transmitting member. The light transmitting member 125 includes, for example, a silicone resin.

The wavelength conversion member 126 covers the light transmitting member 125 and is fixed to the frame member 123. The wavelength conversion member 126 includes a plurality of fluorescent particles which radiate secondary light in response to the primary light, and a light transmitting resin. The plurality of fluorescent particles are contained in the light transmitting resin. The "light transmitting property" of the resin means that a wavelength of at least some of light rays radiated from the light emitting element 124 and a wavelength of at least some of light rays radiated from the plurality of fluorescent particles can pass through the light transmitting resin.

As described above, an example of the light source 12 is a light emitting diode lamp (LED lamp). Another example of the light source 12 is an organic electroluminescence (organic EL).

Referring to Figs. 2 and 3 again, the light reflective member 2 is disposed ahead of the light reflective member 13 in the light radiation direction of the plurality of light sources 12 with reference to the plurality of light sources 12. In Figs. 2 and 3, the "light radiation direction of the plurality of light sources 12" indicates the negative direction of the imaginary z axis. That is, the light radiation direction of the plurality of light sources 12 indicates a downstream side in a light emission direction of the light emitting device.

The light reflective member 2 includes a light transmitting material. The "light transmitting property" of the light reflective member 2 means that at least some of light rays radiated from the light source 12 can pass through the light reflective member. Examples of the light transmitting material include polymethylmethacrylate (PMMA), acrylic resin, polybutylene terephthalate, polypropylene, acrylonitrile-butadiene-styrene copolymer synthetic resin (ABS resin), polycarbonate, polyester, polyethylene and epoxy resin.

The light reflective member 2 surrounds the plurality of light sources 12. To "surround the plurality of light sources 12" includes not only a structure in which each of the plurality of light sources 12 is surrounded by the light reflective surface 131, as shown in Fig. 4, but also a structure in which the plurality of light sources 12 are surrounded by one light reflective surface 131.

As schematically shown in Fig. 7, some light rays 120a radiated from the light source 12 are reflected by the light reflective member 2 and propagate in the negative direction of the imaginary z axis. A light intensity distribution 901 is formed by the light rays 120a and the like. Other light rays 120b radiated from the light source 12 pass through the light reflective member 2 and propagate in the negative direction of the imaginary z axis since the light reflective member 2 includes a light transmitting material. A light intensity distribution 902 is formed by the light rays 120b and the like.

Since the light emitting device of this embodiment is provided with the light reflective member 2 including the light transmitting material, the light emitting device has a light intensity distribution 900 including the distribution 902. Accordingly, the light emitting device of this embodiment has an appropriate level of light spread and can realize, for example, a pleasant illumination space.

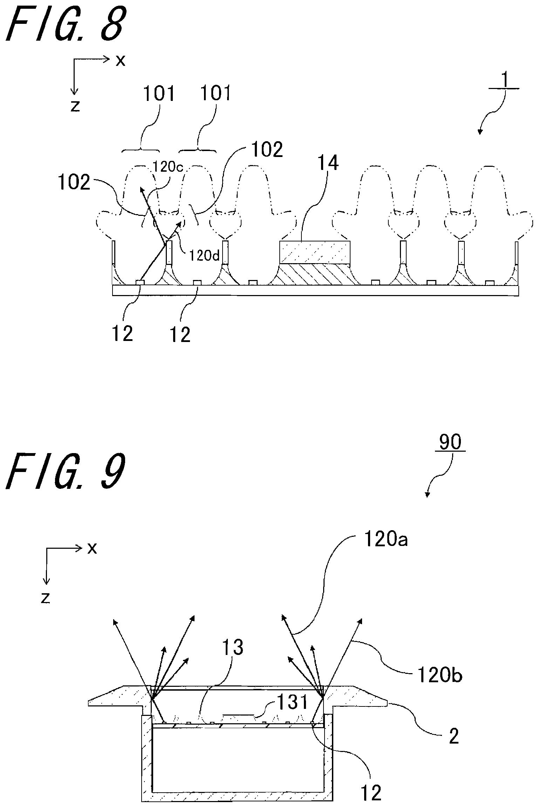

As schematically shown in Fig. 8, in another exemplary light source unit 1, some light rays 120c radiated from the light source 12 are reflected by the light reflective member 14 and propagate in the negative direction of the imaginary z axis. A light intensity distribution 101 is formed by the light rays 120c and the like. Other light rays 120d radiated from the light source 12 pass through the light reflective member 14 and propagate in the negative direction of the imaginary z axis since the light reflective member 14 includes a light transmitting material. A light intensity distribution 102 is formed by the light rays 120d and the like. Due to the overlap of the light intensity distributions 102 of the neighboring light sources 12, another exemplary light source unit 1 can have a continuous light intensity distribution. Accordingly, in another exemplary light source unit 1, unevenness in the light intensity distribution is reduced.

### (Second Embodiment)

A second embodiment of the invention will be described with reference to Fig. 9. A configuration of a light emitting device of the second embodiment that is different from that of the light emitting device of the first embodiment is a configuration of the light reflective member 2. In other respects, the configuration is the same as in the light emitting device of the first embodiment.

The light reflective member 2 of the second embodiment has an inner surface having a rougher surface texture than that of the light reflective surface 131 of the light reflective member 13. The "rougher surface texture than that of the light reflective surface 131" means that the inner surface has higher arithmetic mean roughness Ra than that of the light reflective surface 131. The exemplary arithmetic mean roughness Ra of the inner surface of the light reflective member 2 is in the range of 0.1 µm to 30 µm. The exemplary arithmetic mean roughness Ra of the light reflective surface 131 is in the range of 0.001 µm to 0.1 µm.

Some light rays 120a radiated from the light source 12 are reflected to be scattered in the inner surface of the light reflective member 2. The light emitting device of the second embodiment can properly scatter some light rays 120a radiated from the light source 12. Accordingly, the light emitting device of the second embodiment has an improved light intensity distribution.

### (Third Embodiment)

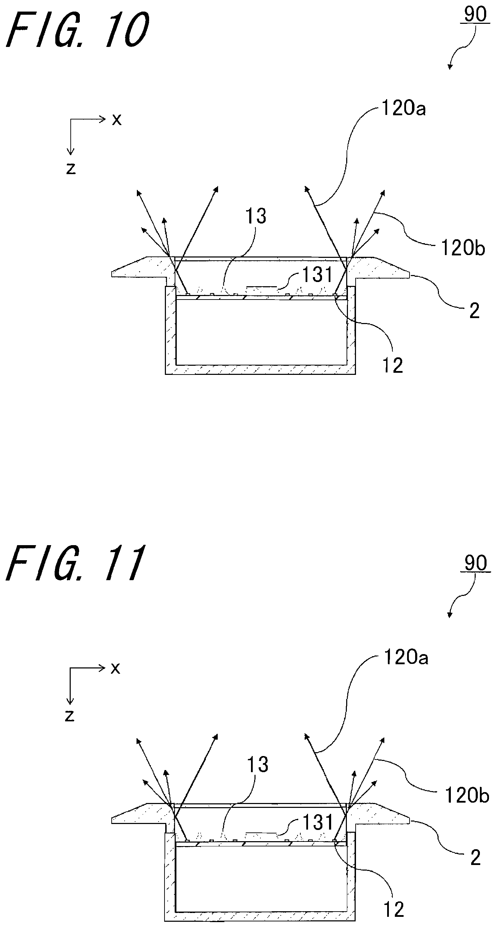

A third embodiment of the invention will be described with reference to Fig. 10. A configuration of a light emitting device of the third embodiment that is different from that of the light emitting device of the first embodiment is a configuration of the light reflective member 2. In other respects, the configuration is the same as in the light emitting device of the first embodiment.

The light reflective member 2 of the third embodiment has an outer surface having a rougher surface texture than that of the light reflective surface 131. The "rougher surface texture than that of the light reflective surface 131" means that the outer surface has higher arithmetic mean roughness Ra than that of the light reflective surface 131. The exemplary arithmetic mean roughness Ra of the outer surface of the light reflective member 2 is in the range of 0.1 µm to 30 µm. The exemplary arithmetic mean roughness Ra of the light reflective surface 131 is in the range of 0.001 µm to 0.1 µm.

Some light rays 120b radiated from the light source 12 pass through the light reflective member 2 so as to be scattered by the outer surface of the light reflective member 2. The light emitting device of the third embodiment can properly scatter light rays 120b radiated from the light source 12. Accordingly, the light emitting device of the third embodiment has an improved light intensity distribution.

### (Fourth Embodiment)

A fourth embodiment of the invention will be described with reference to Fig. 11. A configuration of a light emitting device of the fourth embodiment that is different from that of the light emitting device of the first embodiment is a configuration of the light reflective member 2. In other respects, the configuration is the same as in the light emitting device of the first embodiment.

The light reflective member 2 of the fourth embodiment includes a plurality of light scattering particles. The "light scattering property" of the particles means that the propagation direction of the light radiated from the light source 12 is changed by reflection or light refraction. Some light rays 120b radiated from the light source 12 are reflected or refracted by the light scattering particles in the light reflective member 2. Examples of the material for the light scattering particles include metallic oxide particles such as aluminum oxide, zirconium oxide, titanium oxide and yttrium oxide, glass particles having a refractive index different from that of the light reflective member 2, polymethylmethacrylate (PMMA), acryl, polybutylene terephthalate, polypropylene, acrylonitrile-butadiene-styrene copolymer synthetic resin (ABS resin), polycarbonate, polyester, polyethylene and epoxy resin which have a light transmitting property. The light emitting device of the fourth embodiment can properly scatter the light radiated from the light source 12. Accordingly, the light emitting device of the fourth embodiment has an improved light intensity distribution.

## Claims

1. A light emitting device, comprising:
a plurality of light sources (12) each comprising a light emitting element;
a first light reflective member (13) which surrounds the plurality of light sources; and
a second light reflective member (2) comprising a light transmitting material, the second light reflective member being disposed ahead of the first light reflective member in a light radiation direction of the plurality of light sources with reference to the plurality of light sources,
**characterized in that**
a surface of the first reflective member (13) having arithmetic mean roughness in a range of 0.001 µm to 0.1 µm and a surface of the second reflective member (2) having arithmetic mean roughness in a range of 0.1 µm to 30 µm.

2. The light emitting device according to claim 1,
wherein the second light reflective member (2) includes light scattering particles.

3. The light emitting device according to claim 1,
wherein the first light reflective member (13) has a plurality of first light reflective surfaces (131) corresponding to the plurality of light sources (12), and
the second light reflective member (2) has a second light reflective surface surrounding the plurality of light sources (12).

## Patentansprüche

1. Eine lichtemittierende Vorrichtung, aufweisend:
eine Mehrzahl von Lichtquellen (12), die jeweils ein lichtemittierendes Element aufweisen,
ein erstes lichtreflektierendes Element (13), das die Mehrzahl von Lichtquellen umgibt, und
ein zweites lichtreflektierendes Element (2), das ein lichtdurchlässiges Material aufweist, wobei das zweite lichtreflektierende Element bezüglich der Mehrzahl von Lichtquellen in einer Licht-Strahlungsrichtung der Mehrzahl von Lichtquellen vor dem ersten lichtreflektierenden Element angeordnet ist,
**dadurch gekennzeichnet, dass**
eine Fläche des ersten reflektierenden Elements (13) einen arithmetischen Mittelrauwert in einem Bereich von 0,001 µm bis 0,1 µm hat und eine Fläche des zweiten reflektierenden Elements (2) einen arithmetischen Mittelrauwert in einem Bereich von 0,1 µm bis 30 µm hat.

2. Die lichtemittierende Vorrichtung gemäß Anspruch 1,
wobei das zweite lichtreflektierende Element (2) Lichtstreuungspartikel enthält.

3. Die lichtemittierende Vorrichtung gemäß Anspruch 1,
wobei das erste lichtreflektierende Element (13) eine Mehrzahl von ersten lichtreflektierenden Flächen (131) hat, die der Mehrzahl von Lichtquellen (12) entsprechen, und
das zweite lichtreflektierende Element (2) eine zweite lichtreflektierende Fläche hat, die die Mehrzahl von Lichtquellen (12) umgibt.

## Revendications

1. Un dispositif électroluminescent, comportant :
une pluralité de sources de lumière (12) dont chacune comporte un élément électroluminescent,
un premier élément réfléchissant la lumière (13) qui entoure la pluralité de sources de lumière, et
un deuxième élément réfléchissant la lumière (2) comportant un matériau transmettant la lumière, le deuxième élément réfléchissant la lumière étant disposé en avant du premier élément réfléchissant la lumière dans une direction de rayonnement de lumière de la pluralité de sources de lumière par rapport à la pluralité de sources de lumière,
**caractérisé en ce que**
une surface du premier élément réfléchissant (13) a une rugosité moyenne arithmétique dans une plage de 0,001 µm à 0,1 µm et une surface du deuxième élément réfléchissant (2) a une rugosité moyenne arithmétique dans une plage de 0,1 µm à 30 µm.

2. Le dispositif électroluminescent selon la revendication 1,
dans lequel le deuxième élément réfléchissant la lumière (2) comprend des particules de diffusion de lumière.

3. Le dispositif électroluminescent selon la revendication 1,
dans lequel le premier élément réfléchissant la lumière (13) a une pluralité de premières surfaces réfléchissant la lumière (131) correspondant à la pluralité de sources de lumière (12), et
le deuxième élément réfléchissant la lumière (2) a une deuxième surface réfléchissant la lumière entourant la pluralité de sources de lumière (12).
